# EUROPEAN PATENT APPLICATION

(11) **EP 4 089 525 A1**
(43) Date of publication of application: **16.11.2022**
(21) Application number: 21173614.5
(22) Date of filing: 12.05.2021
(51) Int. Cl.: G06F 8/35, G06F 16/36

(54) **SYSTEM AND METHOD FOR GENERATING PROGRAM CODE FOR AN INDUSTRIAL CONTROLLER**

(71) Applicant: Siemens Aktiengesellschaft, 80333 München (DE)
(72) Inventor: LIU, Kai, 90562 Heroldsberg (DE); QUIROS ARAYA, Gustavo Arturo, 08540 Princeton (US)

(57) **Abstract**

The invention relates to a system and a method for generating program code (AS) for an industrial controller, the method comprising: in a first step, storing first ontology (MSO) of a modelling system and second ontology (ESO) of an industrial engineering system in an engineering knowledge graph database (EKG), in a second step, with the modelling system, developing or changing of a system model (SM) of the program code and/or an automation system with the industrial controller, in a third step, based on the first (MSO) and the second ontology (ESO), transforming the system model (SM) into a knowledge graph representation and storing the knowledge graph representation in the engineering knowledge graph database (EKG), in a fourth step, generating, from the data of the engineering knowledge graph database (EKG), the program code (AS) for the industrial controller, and, in a fifth step, storing the program code (AS) in an industrial engineering system. With this, the knowledge graph concept / system is introduced in the code generation workflow and two sets of ontologies are provided to the knowledge graph system to have a common understanding of both worlds. From the knowledge-based representation of the system model a program code in an industrial automation programming language according to IEC 61131-3 standard can be generated.

## Description

In the automation engineering, during system modeling phase, system models are created to generate automation software code. If changes are made on the generated software code during engineering phase, these changes must be reflected to the original system model to ensure consistency between model and code. In addition, new knowledge gained from concrete system realization needs to be fed back into the original system model to make the system design better.

Up to now, a waterfall workflow of manually creating new models based on generated code modifications is adopted to solve this problem. Once the code is generated, it is not intended to modify the generated code directly. Instead, extension mechanisms are applied to extend the generated code to add new functionalities. For example, with an object-oriented approach, the generated code is encapsulated in a base class and the manually extended code is in a derived class for test. If it makes sense to move the manually added code to the system model, a new model is created manually, and a new base class is generated from the new model. The manually added code can then be discarded. For instance, MATLAB Embedded Coder is using this approach to generate embedded software code from Simulink models.

A knowledge-based cognitive engineering system is known from the publication WO 2019/040076 A1 - Martinez Canedo et al. " A COGNITIVE AUTOMATION ENGINEERING SYSTEM".

To overcome the drawbacks of the state-of-the-art technologies mentioned above, we propose a new approach which is able to transform the code extension back to the original system model. With this approach, automation engineers can generate code from an initial system model, extend the generated code with the best knowledge that they have in the implementation phase. Information about the generated code will then be fed back automatically to the original model. Based on this information, the mechanism enables the user to select which actions to take. The recommendation can be accepted or discarded. The underlying technology is knowledge graph.

The task is solved by the patent claims, in particular by a method according to claim 1 and a system according to claim 6.

The task is solved by a method for generating program code for an industrial controller, the method comprising, in a first step, storing first ontology of a modelling system and second ontology of an industrial engineering system in an engineering knowledge graph database, in a second step, with the modelling system, developing or changing of a system model of the program code and/or an automation system with the industrial controller, in a third step, based on the first and the second ontology, transforming the system model into a knowledge graph representation and storing the knowledge graph representation in the engineering knowledge graph database, in a fourth step, generating, from the data of the engineering knowledge graph database, the program code for the industrial controller, and in a fifth step, storing the program code in an industrial engineering system. With this, the knowledge graph concept / system is introduced in the code generation workflow and two sets of ontologies are provided to the knowledge graph system to have a common understanding of both worlds. From the knowledge-based representation of the system model a program code in an industrial automation programming language according to IEC 61131-3 standard can be generated.

The task is also solved by a system for generating program code for an industrial controller, the system comprising an engineering knowledge graph database for storing first ontology of a modelling system and second ontology of an industrial engineering system and for storing information about the program code and/or an automation system with the industrial controller in form of a knowledge graph representation, a modelling system for developing or changing of a system model of the program code and/or the automation system with the industrial controller, a first translation unit for transforming, based on the first and the second ontology, the system model into the knowledge graph representation and for storing the knowledge graph representation in the engineering knowledge graph database, a second translation unit for generating, from the data of the engineering knowledge graph database, the program code, and an industrial engineering system for compiling the program code to object code for the industrial controller and downloading the object code to the industrial controller. With that system, the advantages described for the inventive method can be achieved.

Advantageous embodiments are given with the dependent patent claims. The features of the dependent patent claims can be combined. Embodiments of the method are also valid for the system, and vice versa.

In one embodiment, for obtaining feedback information from the changes to the program code into the system model, the method further comprises, in a sixth step, modifying the program code with the engineering system, in a seventh step, generating, from the modified program code artifacts, updates for the knowledge graph representation and updating the knowledge graph database with the updates, and, in an eight step, from the modified knowledge graph representation, modifying the system model. By that, system model changes and code modifications are identified e.g. by an engineering rule engine and recommendations are populated to the user for making proper modeling decisions. In particular, changes to the program code can be fed back into the engineering knowledge graph database and to the system model.

In an advantageous embodiment, after the second step, the method comprises notifying, via a user interface, a user about the code generation, the user being invited, via the user interface, to put customizations and/or annotations to the code generation process. By this, an automatic notification mechanism, e.g., via a message queue broker, is introduced in the approach to inform the user immediately the model code mismatch, in order that the user can take actions or ignore irrelevant changes. In fact, a recommendation and user control layer is incorporated to the workflow. This layer works independently from the underlying system modelling language and independently from the industrial control programming language.

In an embodiment, the achieved user interface comprises, after the seventh step, notifying, via the user interface, a user about possible changes, induced by the modified program code artifacts, to the system model, the user being invited to approve, change and/or discard the changes to the system model. In addition, the user interface layer can filter messages so that only relevant changes or questions are presented to the user.

Advantageously, the system model is described by UML (unified Modelling Language), SysML (System Modeling Language), or IML (Interdisciplinary Modeling Language). By this, data exchange with existing modeling tools is possible.

Advantageously, the inventive system comprises a third translation unit for transforming modifications of the program code to new or changed artifacts of the knowledge graph representation.

Further, the system comprises a fourth translation unit for transforming, based on the first and the second ontology, the knowledge graph representation of the knowledge graph engineering database into a new or changed system model.

Advantageously, an Engineering Rule Engine is foreseen for generation of information or requests for a user. In one embodiment, the Engineering Rule Engine is adapted to notify the third or the fourth translation unit about changes for generating a new or changed version of the program code, or a new or changed system model, respectively.

The invention is explained with the drawings.

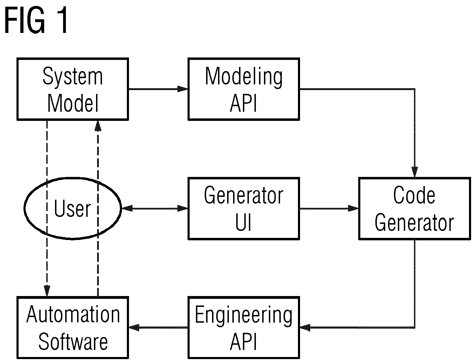

FIG. 1 shows a system according to the prior art. A modelling system, comprising a system model for an automation system or for at least an automation program, comprises a Modeling API. The Modeling API establishes an interface to a Code Generator, the Code Generator transforming / translating the system model into program code (automation program, in particular according to IEC 61131-3 standard) for an industrial automation system, e.g., a PLC (programmable logic controller) or the like. A Generator UI (user interface) provides a user interface. With that, a user can control the code generation process. Target for the generated program code - the Automation Software - is an industrial engineering system. The engineering system comprises an API (application programming interface) or another data exchange capability for obtaining the Automation Software from the Code Generator. The engineering system compiles the program code to object code and downloads the object code to the automation system (e.g. PLC), the automation system executing the program code for controlling an industrial process or the like.

Changes to the Automation Software, e.g., in the course of code debugging with the engineering system, must be fed back manually to the System Model.

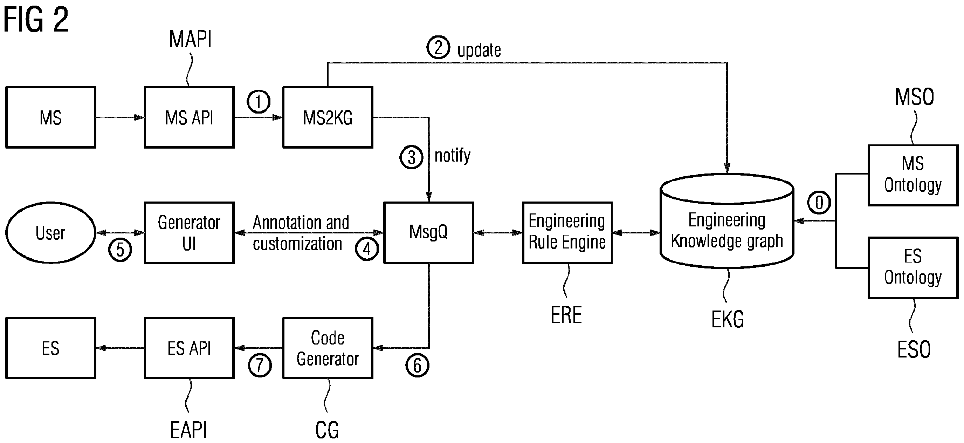

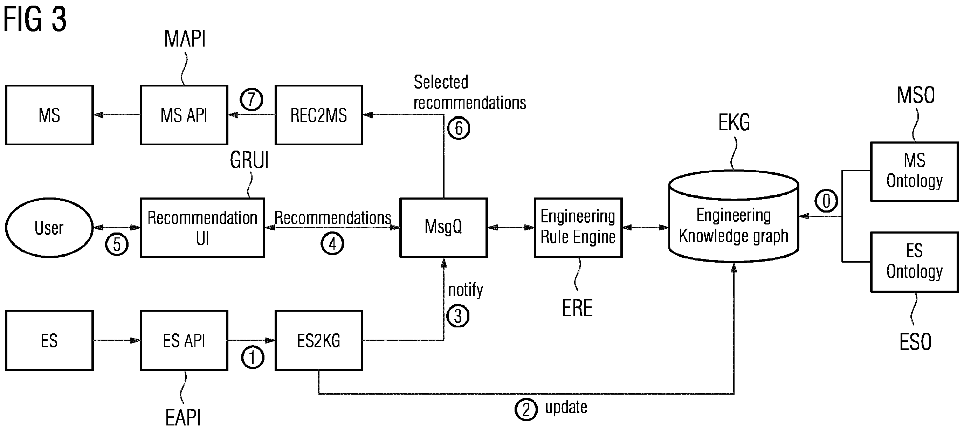

In the following, two scenarios are explained to illustrate the invention in detail. The numbers of the steps in the following description correspond to the reference numbers in FIG. 2 or FIG. 3, respectively. The steps enumerated in the patent claims may be different from the nomenclature used in the embodiments described here.

FIG. 2 explains a first scenario, namely the code generation from a modeling system to an engineering system.

Step (0): In this step, first ontology MSO of the modeling system MS and second ontology ESO of the engineering system ES are fed into the engineering knowledge graph database EKG. The ontologies may comprise requirements, inter-dependencies between devices, implementation details, constraints, and the like. The ontologies can be regarded as rules for the relations between artifacts in the Knowledge Graph representing the System Model SM and the Program Code AS (Automation Software) .

Step (1): Once the system model SM is developed in the modeling system MS, a first translation unit called MS2KG ("Modeling System to Knowledge Graph") transforms the system model SM to the knowledge graph, accessing the modeling system MS via the modeling system's provided Application Programming programming interface depicted as MS API.

Step (2): After the transformation, the knowledge graph is fed into the knowledge graph database EKG.

Step (3): In the meantime, a message is sent to a message broker MsgQ ("Message Queue"), which triggers the Engineering Rule Engine ERE.

Step (4): The Engineering Rule Engine ERE computes the necessary code generation facilities and sends them to the Generator UI (User Interface). The Rule Engine ERE comprises rules which may serve as filter criteria. For example, changes to annotations may not be visualized in the user interface, but structural changes to the system model might demand a user confirmation.

Step (5): The user can trigger the code generation and do the necessary customization and annotation.

Step (6): The generation triggered by the user is sent to a second translation unit, the real Code Generator CG. The Code Generator CG transforms or translates - based on the ontologies MSO, ESO - the knowledge graph representation of the system model SM into program code for an automation system, i.e. for a PLC or the like.

Step (7): The code generator CG utilizes the engineering system's application programming interface ES API to generate the software code. In an embodiment, the Code Generator CG can produce source code. In this case, the engineering system ES compiles the program code to object code and downloads the compiled object code to a target. In other embodiments, the code generator CG may produce some kind of intermediate code or executable code (object code).

The second scenario as shown in FIG. 3, as described hereafter, explains the back-tracing from the engineering system ES to the modeling system MS. This provides automatic or at least semi-automatic feedback from changes made in the engineering-layer to the system modeling layer. Please note that FIG. 3 uses its own reference signs for the method steps, again starting with "0". These step numbers are different from the reference signs of FIG. 2 and different from the step enumeration in the patent claims.

FIG. 3 shows:
Step (0): As in the previously described scenario, the very first step is the fill-out the Engineering Knowledge graph database EKG with first MSO and second ESO ontologies, i.e., modeling ontology (MS Ontology) and engineering system ontology (ES Ontology).

Step (1): Assume that the code generated by the first scenario - or an imported existing program or engineering project - has been modified by the user. The amended code in the engineering system ES is accessed via the application programming interface ES API of the engineering system ES; alternative ways of access are possible. The third translation unit ES2KG ("Engineering System to Knowledge Graph") generates a corresponding knowledge graph or at least parts thereof from the modified engineering artifacts.

Step (2): The third translation unit ES2KG updates the Engineering Knowledge graph database EKG.

Step (3): The third translation unit ES2KG notifies the Engineering Rule Engine ERE via the broker message queue MsgQ.

Step (4): The Engineering Rule Engine ERE calculates the difference between existing modeling triples and engineering triples. An internal recommendation engine is then triggered by the Engineering Rule Engine ERE. The computed recommendations are fed back to the User via the Recommendation UI.

Step (5): The User makes decisions whether he wants to accept or reject the recommendations because not every modification in the code should be reflected to the model. Three typical scenarios are listed below to describe different kinds of actions based on the recommendations:
a. A question example is:
   The plant requires a safety module, do you want to add it to the model?
   The reason of this question is that a safety module was added to the engineering system after the code generation is done. The recommendation system assumes that the modeling system also requires this module at the system level to make the model and code consistent. However, it may happen that it is intended to make this module as implementation dependent, so the user may reject it and the model will be kept unchanged.
b. Another question example is:
   The sorter got an additional sensor PostSorter in plant, feed it back to the model?
   This happens if an additional sensor module is added to the hardware module of the engineering system and the recommendation system detects a model and code mismatch. It makes probably more sense to accept this recommendation and let the system add this module to the model automatically.
c. Another typical example is the model and implementation mismatch. This is due to modeling errors. For instance: It seems that LiftModule and Rack have different interface types in plant, the model should be adapted.
   In this example, LiftModule and Rack are connected to each other over a physical interface, but in the engineering system, their interfaces are different. This knowledge is only available late in the implementation stage. Since the knowledge graph contains both engineering and modeling system knowledge, this inconsistency is detected by the recommendation system. It is normally compulsory to change the model interface to reflect the real system.

Step (6): Once the recommendations are marked as "accepted", the selected ones are fed back to the fourth translation unit REC2MS (Recommendations to Modeling System).

Step (7): The fourth translation unit REC2MS leverages the modeling systems application programming interface MS API to change the model SM; of course, different accessing or communication means might be employed. If it is requested by the user, the first scenario (generating program code from the system model) will run again.

In general, the ontologies describe the relationships between different artifacts. The translation units MS2KG, CG, ES2KG, REC2MS are developed or configured or parametrized based on the ontologies, such that they can understand the relationships of the instance data, i.e., system model or automation software. In many cases the translation units are typically not directly using the ontologies, but they are created or set-up based on the ontologies. Although we use in the instant example one ontology MSO for the modeling system and one ontology ESO for the engineering system, one can also define these each as set of ontologies, thus describing that information in a plural form.

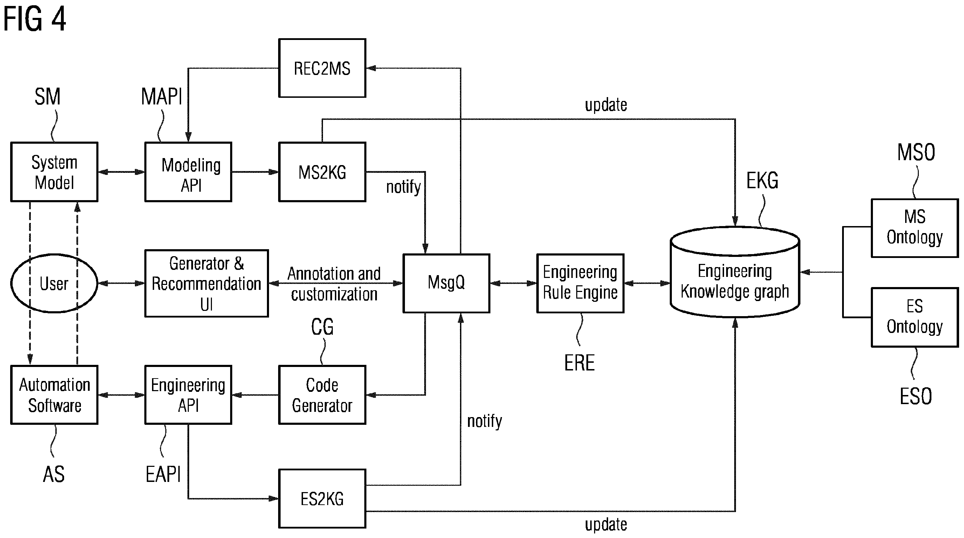

FIG. 4 shows a combination of FIGS. 2 and 3. Thus, the system shown in FIG.4 shows the complete system and workflow for creating program code from the system model and for feeding back changes from the program code to the system model ("closed loop engineering"). FIG. 4 does also show the recommendation layer, comprising the combined Generator & Recommendation UI (depicted GRUI) and parts of the message queue MsgQ.

In comparison to the state-of-the-art technologies, the proposed approach has the following advantages:
- It is not like the state-of-the-art tools (e.g., MATLAB Embedded Coder), where the code is generated directly from the model, which makes it impossible to trace the changes afterwards to the original model. In the described approach, however, the code generation is done over the central knowledge graph database, which understands both engineering and modeling system ontologies.
- Separation of concerns: there is no simple update between engineering system and modeling system. Instead, in an advantageous embodiment a recommendation layer is introduced, which enables more user controls, because the user knows the requirement better than the knowledge graph system. The knowledge graph system is responsible for analyzing the data collected from both sides and calculating the dependencies. It processes the collected information and delegates to the recommendation system to make user-friendly recommendations. Depending on the user's choice, the corresponding actions will be taken.

- We can apply this mechanism to create a cognitive modeling system and an associated code generator. With the improved modeling capability, a user will be able to work at a higher level of abstraction. The building blocks are provided directly by the engineering system and the recommendations are made to the modeling system according to the hardware catalog in the engineering system. Most of code can be generated from the modeling system. Only some implementation-specific code needs to be implemented manually. Even this small piece of implementation-specific code can be fed back to the modeling system, due to the provided mechanism. The entire engineering lifecycle is then a closed loop.
- The modeling recommendation system can be used to introduce the knowledge gained from legacy code and generate models to the modeling system.
- An automatic notification mechanism via the message queue broker is introduced in the approach to inform the users immediately the model code mismatch, in order that the users can take actions or ignore irrelevant changes.
- Advantageous aspects of the presented method and system are, inter alia:
   1) A knowledge graph system is introduced in the code generation workflow and two sets of ontologies are provided to the knowledge graph system to have a common understanding of both worlds.
   2) System changes and code modifications are identified by the engineering rule engine and recommendations are populated to the user for making proper modeling decisions. Changes in the system model can be reflected to the program code, and vice versa. Close loop engineering is possible while a user keeps control of the code generation and modification of the system model.

## Claims

1. A method for generating program code (AS) for an industrial controller, the method comprising:
in a first step, storing first ontology (MSO) of a modelling system and second ontology (ESO) of an industrial engineering system in an engineering knowledge graph database (EKG),
in a second step, with the modelling system, developing or changing of a system model (SM) of the program code and/or an automation system with the industrial controller,
in a third step, based on the first (MSO) and the second ontology (ESO), transforming the system model (SM) into a knowledge graph representation and storing the knowledge graph representation in the engineering knowledge graph database (EKG),
in a fourth step, generating, from the data of the engineering knowledge graph database (EKG), the program code (AS) for the industrial controller, and
in a fifth step, storing the program code (AS) in an industrial engineering system.

2. The method of claim 1,
**characterized in,**
**that** for obtaining feedback information from the changes to the program code (AS) into the system model (SM), the method further comprising:
in a sixth step, modifying the program code (AS) with the engineering system (ES),
in a seventh step, generating, from the modified program code (AS) artifacts, updates for the knowledge graph representation and updating the knowledge graph database (EKG) with the updates, and
in an eight step, from the modified knowledge graph representation, modifying the system model (SM).

3. The method of one of the preceding claims,
**characterized in, that**
after the second step, notifying, via a user interface, a user about the code generation, the user being invited, via the user interface, to put customizations and/or annotations to the code generation process.

4. The method of one of the preceding claims,
**characterized in, that**
after the seventh step, notifying, via a user interface, a user about possible changes, induced by the modified program code (AS) artifacts, to the system model (SM), the user being invited to approve, change and/or discard the changes to the system model (SM).

5. The method of one of the preceding claims,
**characterized in, that**
the system model is described in UML, SysML or IML language.

6. A system for generating program code for an industrial controller, the system comprising:
an engineering knowledge graph database (EKG) for storing first ontology (MSO) of a modelling system and second ontology (ESO) of an industrial engineering system and for storing information about the program code (AS) and/or an automation system with the industrial controller in form of a knowledge graph representation,
a modelling system (MS) for developing or changing of a system model (SM) of the program code (AS) and/or the automation system with the industrial controller,
a first translation unit (MS2KG) for transforming the system model into the knowledge graph representation and for storing the knowledge graph representation in the engineering knowledge graph database (EKG),
a second translation unit (CG) for generating, from the data of the engineering knowledge graph database (EKG) and based on the first (MSO) and the second ontologies (ESO), the program code (AS), and
an industrial engineering system (ES) for compiling the program code (AS) to object code and downloading the object code to the industrial controller.

7. The system of claim 6,
**characterized in**
a third translation unit (ES2KG) for transforming modifications of the program code (AS) to new or changed artifacts of the knowledge graph representation.

8. The system of claim 6 or 7,
**characterized in**
a fourth translation unit (REC2MS) for transforming the knowledge graph representation, based on the first (MSO) and the second ontology (ESO), of the knowledge graph engineering database (EKG), into a new or changed system model (SM).

9. The system of one of claims 6 to 8,
**characterized in**
an Engineering Rule Engine (ERE) for generation of information and/or requests for a user.

10. The system of claim 9,
**characterized in**
**that** the Engineering Rule Engine (ERE) is adapted to notify the third (ES2KG) or the fourth (REC2MS) translation unit about changes for generating a new or changed version of the program code (AS), or a new or changed system model (SM), respectively.
